# EUROPEAN PATENT APPLICATION

(11) **EP 1 655 777 A1**
(43) Date of publication of application: **10.05.2006**
(21) Application number: 04770893.8
(22) Date of filing: 23.07.2004
(51) Int. Cl.: H01L 23/12

(54) **IN-PRINT METHOD AND IN-PRINT DEVICE**

(30) Priority: 25.07.2003 JP 2003279950
(71) Applicant: TOKYO ELECTRON LIMITED, Minato-ku, Tokyo 107-8481 (JP)
(72) Inventor: ARUGA, Tsuyoshi, Tokyo Electron AT Limited, Nirasaki-shi, Yamanashi 4078511 (JP); HAGIHARA, Junichi, Tokyo Electron AT Limited, Nirasaki-shi, Yamanashi 4078511 (JP)
(74) Representative: Liesegang, Eva
(86) International application number: PCT/JP2004/010500
(87) International publication number: WO 2005/010986

(57) **Abstract**

An imprinting method of the present invention is to press a mold member (40) having thereon a mold pattern onto a film carried on a principal plane of a substrate (50) as an object to be processed, so as to transfer the mold pattern to the film. A plurality of substrates (50) are fixed on a chuck stage (20). One of the substrates (50) can be selectively heated by a heater (21) and a cooling line (22). The mold member (40) is fixed on a head plate (30) which is disposed to be opposed to the chuck stage (20). The selectively heated substrate (50) and the mold member (40) are positioned relative to each other, and the mold member (40) is pressed onto a film on the substrate (50). By repeating this operation, all the substrates (50) are imprinted.

## Description

### TECHNICAL FIELD

The present invention relates to an imprinting method and an imprinting apparatus for use in manufacturing, e.g., a semiconductor device, in which a mold member having thereon a mold pattern, such as a circuit pattern, is pressed onto a film carried on a principal plane of an object to be processed, whereby the mold pattern is transferred to the film.

### BACKGROUND ART

In fabrication of a semiconductor device, a packaging structure, such as a system-in package (SiP) that contains a plurality of chips and passive elements of different functions, has been proposed. When a bonding wire is used in such a small-sized, high-density packaging structure to connect chips or to connect a chip to a wiring substrate, such as an interposer, the packaging structure suffers the following drawback. That is, a high frequency noise is generated when an electrical potential falls upon switching, because of a large mechanical impact on the chips, a limited wiring density, and a large inductance of a power source / ground wiring. When a solder bump is used in place of a bonding wire, a wiring density is limited by the dimensions of the bump. In addition, since the solder bump is made of a different kind of metal, the solder bump is not adapted for speeding up the device.

Thus, instead of using such a bonding wire and solder bump, a packaging structure has been recently employed, in which semiconductor wafers, chips, and wiring structures such as Cu exposed on a wiring substrate are directly bonded to external connection electrodes (for example, Japanese Patent Laid-Open Publication No. 2001-53218).

There is an ongoing demand for realizing a finer wiring pattern of a wiring substrate, such as an interposer, which is used in the above packaging structure. In order to cope with this need, an imprinting art can be employed. The imprinting art creates a pattern in a film, by pressing a mold pattern formed on a mold member onto an insulation film carried on a substrate so as to transfer the pattern to the film. For example, a specification of US Patent No. 5,772,905 describes an imprinting art which is used in a manufacturing step of a semiconductor device.

With a view to improving a throughput in imprinting process, it is useful to collectively press a plurality of mold members onto a plurality of objects to be processed. However, a collective imprint of a plurality of objects may require a pressing force as large as several tons. Thus, it seems difficult to simultaneously achieve an improvement in throughput and a positioning of the mold members and objects with a degree of precision of high enough to be measured in units of a few micrometers. When both the requirements are forcibly realized, there is concern that an imprinting apparatus may become significantly expensive.

### DISCLOSURE OF THE INVENTION

An object of the present invention is to provide an imprinting art which makes it possible to more precisely position a mold member and an object to be processed, so as to realize a finer transfer pattern to simultaneously achieve an enhanced positioning precision and an improvement in throughput.

The present invention provides a first imprinting method of pressing a mold member having thereon a mold pattern onto a film carried on a principal plane of an object to be processed, so as to transfer the mold pattern to the film, the imprinting method comprising the steps of:
(a) arranging a plurality of objects to be processed to be substantially flush with each other; and
(b) transferring the mold pattern to the films carried on the objects by repeating the sub-steps of:
   (b1) selectively heating one of the arranged objects;
   (b2) positioning the heated object and the mold member relative to each other; and
   (b3) pressing the mold member onto the film carried on the object.

The present invention provides a second imprinting method of pressing a mold member having thereon a mold pattern onto a film carried on a principal plane of an object to be processed, so as to transfer the mold pattern to the film, the imprinting method comprising:
a first step of forming an assembly containing therein the object and the mold member fixedly held in position relative to each other; and
a second step of clamping the assembly to relatively press the mold member onto the object to transfer the mold pattern to the film.

The present invention provides a first imprinting apparatus for pressing a mold member having thereon a mold pattern onto a film carried on a principal plane of an object to be processed, so as to transfer the mold pattern to the film, the imprinting apparatus comprising:
a holding table for holding a plurality of objects, the holding table including a temperature controlling mechanism capable of independently controlling a heating temperature of each of the objects held by the holding table;
a supporting member for supporting the mold member, the supporting member being disposed to be opposed to the holding table;
a positioning mechanism for positioning the mold member supported by the supporting member and the object held on the holding table relative to each other; and
a pressing mechanism for pressing the supporting member toward the holding table.

The present invention provides a second imprinting apparatus for pressing a mold member having thereon a mold pattern onto a film carried on a principal plane of an object to be processed, so as to transfer the mold pattern to the film, the imprinting apparatus comprising:
a first apparatus including a positioning mechanism for positioning the object and the mold member relative to each other, and a fixing mechanism for fixedly holding the object and the mold member in position relative to each other, the first apparatus forming an assembly containing therein the object and the mold member fixedly held in position relative to each other; and
a second apparatus for clamping the assembly to relatively press the mold member onto the object to transfer the mold pattern to the film.

According to the first imprinting method and the first imprinting apparatus of the present invention, a plurality of objects to be processed can be continuously imprinted, by repeating an operation of pressing a mold member onto a film on the object which has been selectively heated. Since only a small pressing force is required for every imprinting operation, it is possible to precisely position the object to be processed and the mold member relative to each other. Therefore, a finer transfer pattern can be achieved. The repeated imprinting operations for the plurality of objects to be processed can improve a throughput.

According to the second imprinting method and the second imprinting apparatus of the present invention, it is possible to separately perform a first step (step carried out by a first apparatus), in which an assembly containing therein objects to be processed and mold members fixedly held in position relative to each other is formed, and a second step (step carried out by a second apparatus), in which the assembly is clamped to transfer mold patterns of the mold members to films carried on the objects. Therefore, in the first step, the first apparatus capable of carrying out a precise positioning operation is used. Exertion of a large pressing force is not required for the first apparatus. In the second step, the second apparatus capable of exerting a relatively large pressing force (e.g., several tons) is used for a collective imprinting of the plurality of objects to be processed. A positioning precision is not required for the second apparatus. Therefore, because of the enhanced positioning precision of the mold members and the objects to be processed, a finer transfer pattern can be achieved. Since the assembly containing the plurality of objects to be processed and the mold members is formed in the first step (step carried out by the first apparatus), a throughput can be improved.

As stated above, according to the present invention, it is possible to simultaneously realize, in an imprinting process, a precise positioning of a mold member and an object to be processed relative to each other, and an improvement in throughput.

### BRIEF DESCRIPTION OF THE DRAWINGS

Fig. 1 is a sectional view of an imprinting apparatus in a first embodiment of the present invention;
Figs. 2(a) and 2(b) are partially enlarged sectional views each showing an operation of the imprinting apparatus shown in Fig. 1;
Fig. 3 is a plan view of a part of the imprinting apparatus shown in Fig. 1;
Figs. 4(a) and 4(b) are sectional views of examples of a mold member and a substrate to be processed used in the imprinting apparatus shown in Fig. 1;
Fig. 5 is a sectional view of a first apparatus of an imprinting apparatus in a second embodiment of the present invention;
Fig. 6 is a sectional view showing an operation of the first apparatus shown in Fig. 5;
Fig. 7(a) is a plan view of a substrate to be processed used in the second embodiment;
Fig. 7(b) is a sectional view of the substrate to be processed used in the second embodiment;
Fig. 8 is a sectional view of an assembly fabricated by the first apparatus shown in Fig. 5;
Fig. 9 is a second apparatus of the imprinting apparatus in the second embodiment;
Figs. 10(a) to 10(c) are side views showing sequential operations of a desorption apparatus in the second embodiment;
Fig. 11 is a sectional view of an imprinting apparatus in a third embodiment of the present invention;
Figs. 12(a) and 12(b) are views showing operations of the imprinting apparatus shown in Fig. 11 from a direction of the arrow A; and
Figs. 13(a) to 13(e) are sectional views sequentially showing an example of manufacturing steps of a multi-layered wiring structure in which a substrate which has been subjected to the imprinting process according to the present invention is used.

### BEST MODE FOR CARRYING OUT THE INVENTION

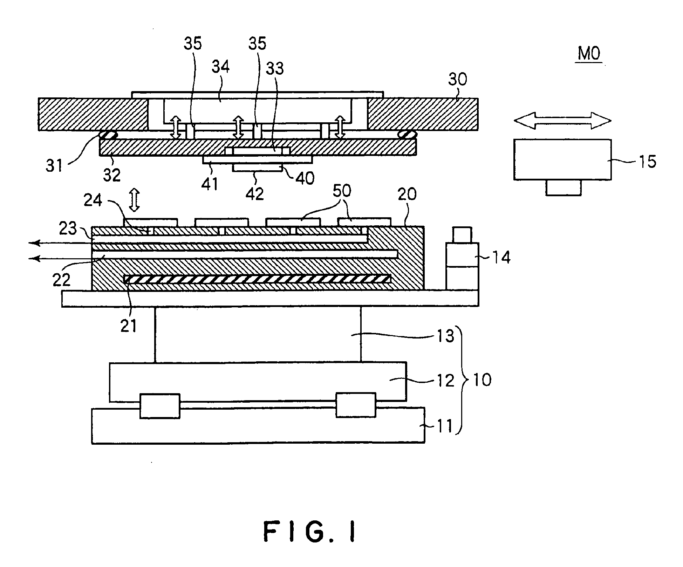

Embodiments of the present invention will be described in detail below, with reference to the accompanying drawings.
A first embodiment of the present invention is initially described referring to Figs. 1 to 4.

An imprinting apparatus M0 in the first embodiment shown in Fig. 1 includes a positioning mechanism 10. The positioning mechanism 10 is provided with a Y-axis table 11, an X-axis table 12, and a Z-axis table 13, which are stacked in a vertical direction. The Y-axis table 11 and the X-axis table 12 are moved in a horizontal plane in directions perpendicular to each other. The Z-axis table 13 disposed on the Y-axis table 11 and the X-axis table 12 is moved upward and downward.

A chuck stage (holding table) 20 is disposed on the positioning mechanism 10. The chuck stage 20 is capable of rotating about the Z-axis in a θ rotational direction. Displacement of the chuck stage 20 in the horizontal plane is controlled by displacement of the Y-axis table 11 and the X-axis table 12 of the positioning mechanism 10, while displacement of the chuck stage 20 in the vertical direction is controlled by displacement of the Z-axis table 13 of the positioning mechanism 10. A position of the chuck stage 20 about the Z-axis in the θ rotational direction is controlled by rotational displacement of the chuck stage 20.

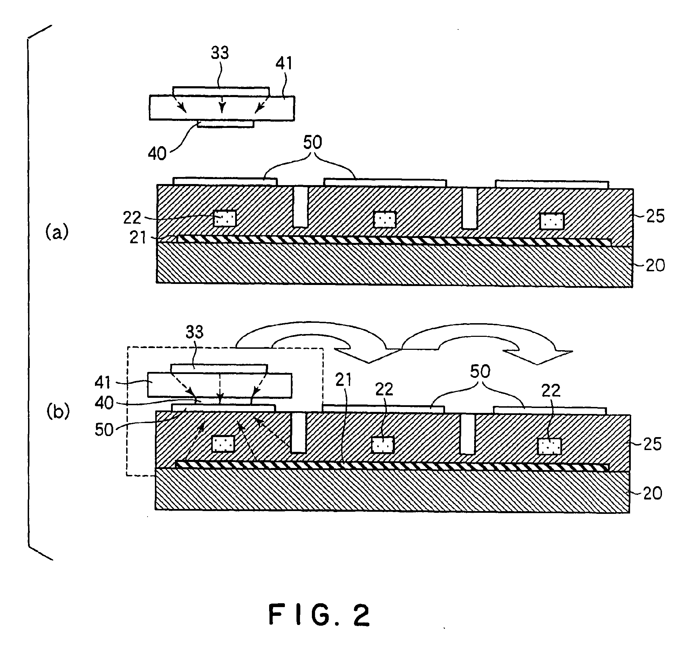

As shown in Figs. 1 and 2, an upper surface of the chuck stage 20 is divided into a plurality of chuck tops 25. An object to be processed, such as a substrate 50, is held on each of the chuck tops 25. As shown in Fig. 1, a plurality of vacuum suction holes 24 are opened in the respective chuck tops 25. The vacuum suction holes 24 are connected to an external vacuum evacuating mechanism, not shown, through a vacuum suction channel 23. The substrate 50 is sucked by the vacuum suction hole 24, and is held on the chuck top 25.

A work heater 21 is disposed inside the chuck stage 20, so that the plurality of substrates 50 held on the chuck stage 20 can be heated to a predetermined temperature. A cooling line 22 through which a cooling medium such as a cooling water flows is disposed inside the chuck stage 20 at a position between the work heater 21 and the plurality of substrates 50. The cooling line 22 can allow or prevent the flow of the cooling medium to an area corresponding to each of the chuck tops 25. Thus, a heat conduction from the work heater 21 to the respective chuck tops 25 can be controlled, to thereby independently control a temperature of each of the substrates 50 held on the corresponding chuck top 25.

A head plate 30 is disposed above the chuck stage 20, which are opposed to each other. A heat-insulation plate 32 is supported by the head plate 30 in a floating manner through a suspension 31. A mold member 40 is fixed on a center part of the heat-insulation plate 32 through a mold substrate (second holding member) 41. The mold member 40 has a predetermined mold pattern 42 formed on a surface facing the substrate 50.

A mold heater 33 for controlling a temperature of the mold member 40 is disposed on a rear side of the mold substrate 41. A head attitude controlling mechanism 34 is disposed on a rear side of the heat-insulation plate 32 on which the mold member 40 is fixed. The head attitude controlling mechanism 34 controls an attitudettitude, such as a parallelism, of the mold member 40 relative to the substrate 50 by means of a plurality of stretchable displacing mechanisms 35. Therefore, the attitude of the mold member 40 is controlled such that the mold member 40 is opposed in parallel with the substrate 50.

The chuck stage 20 has a mold position detecting camera 14 that picks up an image of the mold member 40 opposed to the chuck stage 20, in order to detect a position of the mold member 40. A work position detecting camera 15 is disposed (supported by a not-shown camera bridge) above the chuck stage 20. The work position detecting camera 15 is capable of horizontally moving between the chuck stage 20 and the head plate 30. The camera 15 picks up an image of the substrate 50 held on the chuck stage 20, so that a position of the substrate 50 can be detected.

The positioning mechanism 10 and the head attitude controlling mechanism 34 are controlled based on the position detection results obtained by the mold position detecting camera 14 and the work position detecting camera 15. Thus, a position and attitude of the mold member 40 can be set relative to each of the substrates 50, which is described below.

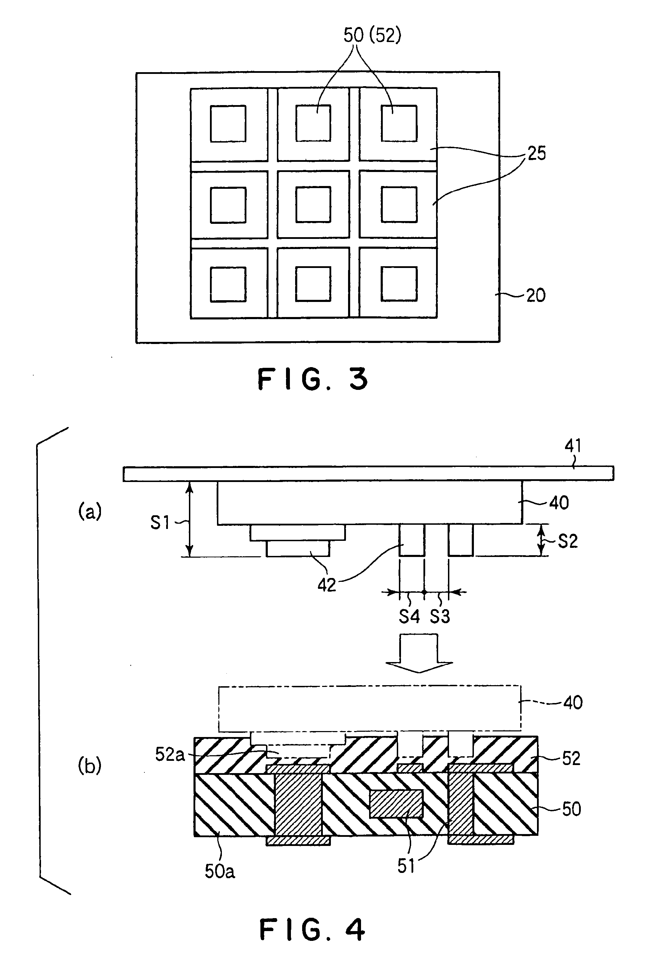

As shown in Fig. 4, the mold member 40 supported by the mold substrate 41 is an electrotyping mold made of Ni or the like, which is manufactured by an electroforming process, for example. The mold member 42 has the fine mold pattern 42 provided on its surface facing the substrate 50. The mold member 40 measures about 300 µm at S1, 40 µm at S2, 10 µm at S3, and 10 µm at S4, for example.

The substrate 50 includes an insulation substrate 50a, and wiring structures 51 formed on front and rear surfaces of the insulation substrate 50a and inside thereof. In the first embodiment, a resin film 52 on which the mold pattern 42 is transferred by an imprinting process is carried on a front or a rear surface of the substrate 50 as a principal plane thereof.

An imprinting method carried out by the imprinting apparatus in the first embodiment is described below.
First, the mold member 40 is attached to the head plate 30, and the substrates 50 arranged on the respective chuck tops 25 of the chuck stage 20 are sucked by the vacuum suction holes 24 to be held on the chuck tops 25.

At this time, the mold member 40 has been heated by the mold heater 33 at a predetermined heat-curing temperature (e.g., 100°C) of the resin film 52, and the work heater 21 has been heated at a predetermined heat-curing temperature. Meanwhile, a cooling water is allowed to flow through the cooling line 22, so as to block a heat transmission from the work heater 21 to the substrates 50. Thus, the substrates 50 are heated at a temperature of about, e.g., 50°C which is restrained to be lower than the temperature of the work heater 21.

Next, positions of the mold member 40 and the substrate 50 are detected by the mold position detecting camera 14 and the work position detecting camera 15.
Thereafter, the flow of water to the certain chuck top 25 through the cooling line 22 is prevented, so that only the temperature of the substrate 50 held on the certain chuck top 25 is selectively raised to the heat-curing temperature. As shown in Fig. 2(a), the mold member 40 is positioned immediately above the substrate 50 which has been heated at the heat-curing temperature. This positioning operation is carried out by controlling the positioning mechanism 10 based on the position detection results obtained by the cameras 14 and 15. At the same time, the attitude of the mold member 40 is oriented in parallel with the substrate 50 by controlling the head attitude controlling mechanism 34 based on the position detection results.

Subsequently, as shown in Fig. 2(b), the Z-axis table 13 of the positioning mechanism 10 is raised so that the mold member 40 is pressed onto the substrate 50. Thus, as shown in Figs. 4(a) and 4(b), the mold pattern 42 of the mold member 40 is pushed into the resin film 52 on the substrate 50. Accordingly, a transfer pattern 52a such as a groove pattern or hole pattern whose configulation is inverse to that of the mold pattern 42 is formed in the resin film 52. Since the substrate 50 has been heated at the heat-curing temperature, the resin film 52 cures with the transfer pattern 52a being formed therein. Although various thermosetting resins can be used as the resin film 52, an epoxy resin is preferred in terms of a low dielectric constant.

In the course of pressing the mold member 40 onto the substrate 50, a raising speed of the Z-axis table 13 is controlled such that a pressing force caused by the raise of the Z-axis table 13 is gradually increased. Thus, a required pressing force can be attained, while discharging an air between the substrate 50 and the mold member 40.

After the mold pattern 42 is transferred on the resin film 52, the Z-axis table 13 is lowered to bring the substrate 50 apart from the mold member 40. Meanwhile, the cooling water is again allowed to flow through the cooling line 22 corresponding to the chuck top 25 holding the substrate 50, so that the temperature of the substrate 50 is lowered to 50°C. In this manner, a transfer of the mold pattern 42 on the resin film 52 carried on one of the substrates 50 is completed.

Following to the above operation, the same imprinting operation is repeated by sequentially moving and positioning the mold member 40 relative to the rest substrates 50 to thereby complete a transfer (imprint) of the mold pattern 42 to all the resin films 52 on the substrates 50.

As stated above, in the first embodiment, since the imprinting operation for each of the substrates 50 is repeatedly carried out, only a small pressing force is required for every imprinting operation. Thus, the substrate 50 and the mold member 40 can be precisely positioned relative to each other. In addition, since the moving, positioning, and imprinting operations of the mold member 40 are repeatedly carried out for the plurality of substrates 50, a throughput can be improved. That is, it is possible to simultaneously achieve, in the imprinting operation, an improvement in precise positioning of the mold member 40 and the substrate 50 relative to each other, and an improvement in throughput.

Means for controlling the temperature of the chuck top 25 on which the substrate 50 is held is not limited to allowing or preventing the flow of water through the cooling line 22. For example, the plurality of independent work heaters 21 may be disposed to correspond to the respective chuck tops 25, so as to independently control the temperatures of the chuck tops 25.

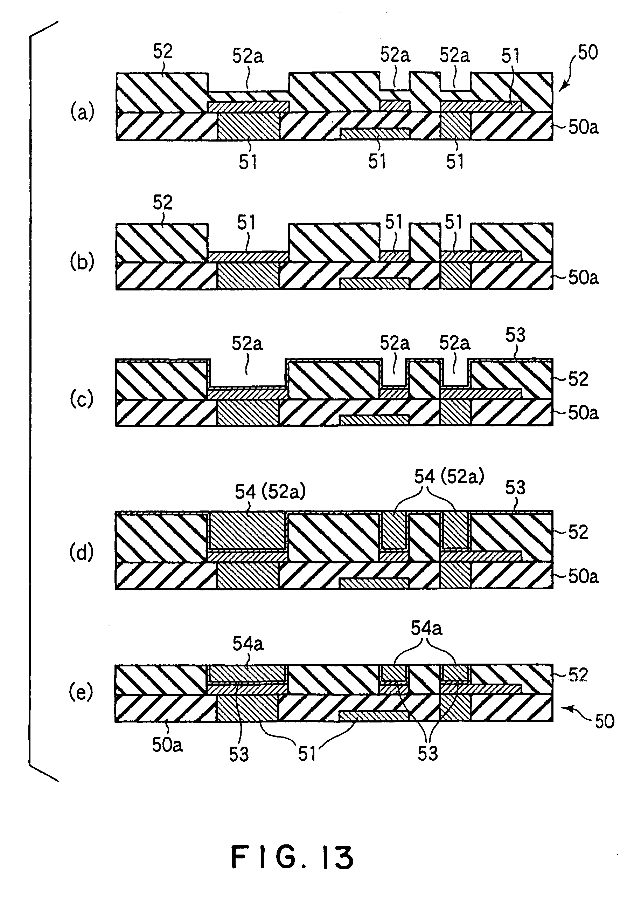

Alternatively, it is possible to allow or prevent the flow of water to the cooling line 22 with respect to the chuck tops 25 in each row or the chuck tops 25 in each column, so as to carry out the imprinting operation for each row and each column.
The substrate 50 having the transfer pattern 52a imprinted on the resin film 52 in accordance with the above-described manner is then subjected to, e.g., a process for forming a multi-layered wiring structure shown in Fig. 13.

Fig. 13(a) is a sectional view of the substrate 50 which was already subjected to the imprinting process. The transfer pattern 52a is imprinted on the resin film 52. As shown in Fig. 13(b), a part of the resin on a bottom of the transfer pattern 52a is removed to expose the lower wiring structure 51, in order to connect the transfer pattern 52a to the lower wiring structure 51. This removal process can be carried out by a laser irradiation, a reactive ion etching (RIE), and so on.

Then, as shown in Fig. 13(c), a seed layer 53 made of a conductive material is formed all over the resin film 52 including the transfer pattern 52a by spattering or the like. Next, as shown in Fig. 13(d), a conductive material 54 such as Cu is buried in the transfer pattern 52a by plating or the like. Finally, as shown in Fig. 13(e), a surface of the resin film 52 is polished to remove the excessive conductive material 54, so that a wiring structure 54a which is electrically connected to the lower wiring structure 51 is completed.

If necessary, the resin film 52 is formed on the substrate 50 shown in Fig. 13(e), and the above-described imprinting operation and the steps shown in Figs. 13(b) to 13(e) are repeated for required number of times, whereby a multi-layered wiring structure having the given number of layers can be obtained.

Generally, Cu is used as a material of wirings in a wiring substrate, such as an interposer, which is used in a packaging structure of a semiconductor device. However, since Cu is difficult to be applied by a photographic method using a dry etching, a wet etching must be unavoidably used. However, the wet etching cannot respond to the recent need for a finer wiring pattern.

Therefore, it is preferable, as in the first embodiment, to employ the imprinting technique for forming a pattern such as a wiring pattern or through-hole, by pressing the mold pattern 42 formed on the mold member 40 onto an insulation film such as the resin film 52 on the substrate 50, to thereby transfer the mold pattern 42 on the resin film 52. That is, Cu is buried by plating in a pattern imprinted in an insulation film, and a surface of the insulation film is polished to remove the excessive Cu, so that a required Cu wiring pattern can be formed in the pattern in the insulation film with a high precision.

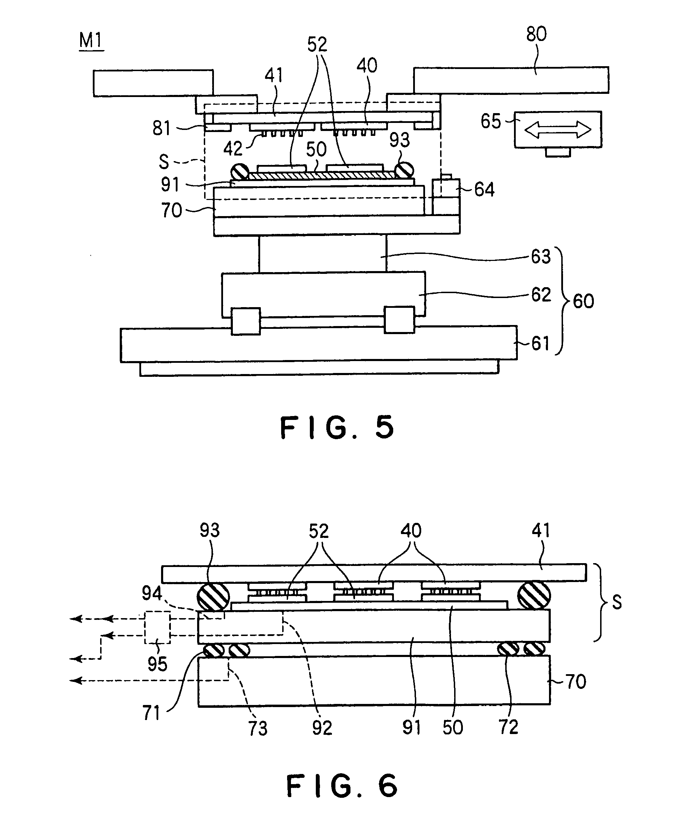

A second embodiment of the present invention is described below, with reference to Figs. 5 to 10. In the second embodiment, a first step, in which an object to be processed and a mold member are positioned relative to each other, and a second step, in which the mold member is pressed onto the object to be processed, are carried out by separate apparatuses (a first apparatus and a second apparatus).

As shown in Fig. 5, the first apparatus (positioning and fastening apparatus) M1 includes a positioning mechanism 60. The positioning mechanism 60 is provided with a Y-axis table 61, an X-axis table 62, and a Z-axis table 13, which are stacked in a vertical direction. The Y-axis table 61 and the X-axis table 62 are moved in a horizontal plane in directions perpendicular to each other. The Z-axis table 63 disposed on the Y-axis table 61 and the X-axis table 62 is moved upward and downward.

A chuck stage 70 is disposed on the positioning mechanism 60. The chuck stage 70 is capable of rotating about the Z-axis in a θ rotational direction. Displacement of the chuck stage 70 in the horizontal plane is controlled by displacement of the Y-axis table 61 and the X-axis table 62 of the positioning mechanism 60, while displacement of the chuck stage 70 in the vertical direction is controlled by displacement of the Z-axis table 63 of the positioning mechanism 60. A position of the chuck stage 70 in the θ rotational direction around the Z-axis is controlled by rotational displacement of the chuck stage 70.

As shown in Fig. 6, a pair of inner and outer sealing members 71 and 72 are disposed on an upper surface of the chuck stage 70. A vacuum suction channel 73 is opened in the upper surface of the chuck stage 70 at a position between the sealing members 71 and 72. An assembly substrate (first holding member) 91 is detachably fixed on the chuck stage 70 by a suction operation of the vacuum suction channel 73.

A substrate 50 disposed on the assembly substrate 91 is detachably fixed thereon by a vacuum suction channel 92 disposed on the assembly substrate 91. A sealing member 93 is disposed on the assembly substrate 91 at a position surrounding the substrate 50. A vacuum suction channel 94 is opened inside the sealing member 93. A space defined inside the sealing member 93 can be evacuated to create therein a vacuum by the vacuum suction channel 94. A control valve 95 for controlling opening and closing operations of the vacuum suction channels 92 and 94 is formed integrally with the assembly substrate 91.

A head plate 80 is disposed above the chuck stage 70, which are opposed to each other. A mold substrate 41 is detachably fixed on the head plate 80 through a clamp mechanism 81. A plurality of molding members 40 are disposed on a bottom surface of the mold substrate 41, such that a mold pattern 42 formed on each of the mold members 40 faces the substrate 50.

The chuck stage 70 has a mold position detecting camera 64 that detects positions of the respective mold members 40 opposed to the chuck stage 70. A work position detecting camera 65 capable of horizontally moving between the chuck stage 70 and the head plate 80 is disposed above the chuck stage 70. The camera 65 can detect a position of the substrate 50 held on the chuck stage 70.

The positioning mechanism 60 is controlled based on the position detection results obtained by the mold position detecting camera 64 and the work position detecting camera 65. Thus, the respective mold members 40 can be positioned relative to the substrate 50, which is described below.

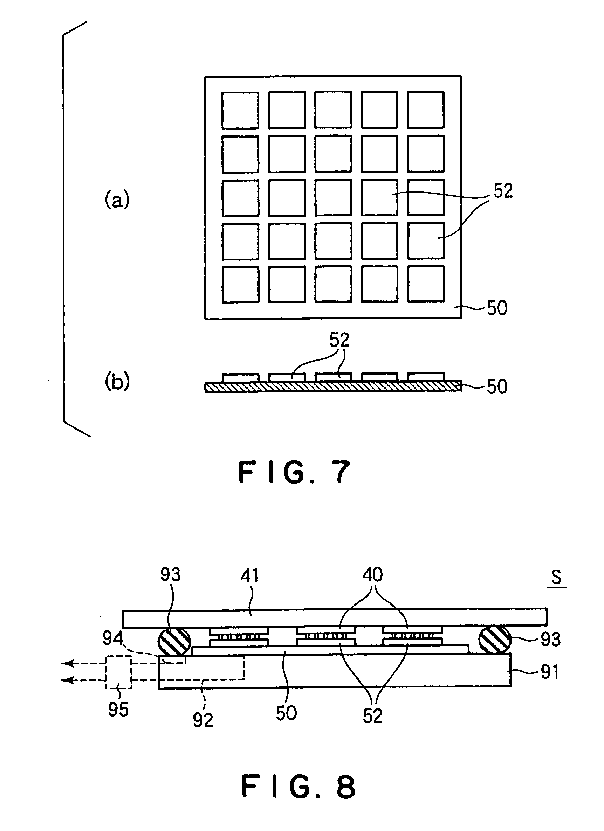

As shown in Fig. 7, in the second embodiment, resin films 52 are applied on a plurality of divided regions of the substrate 50. The divided regions each having the resin film 52 applied thereon are regularly arranged with a predetermined gap therebetween in lateral and longitudinal (X - Y) directions. The mold members 40, whose number is the same as that of the divided regions of the substrate 50 on which the resin films 52 are applied, are arranged on a bottom surface of the mold substrate 41, such that each of the mold members 40 corresponds to the respective divided regions (Figs. 5 and 6).

The first step of the imprinting method carried out by the first apparatus M1 is described below.
First, the substrate 50 shown in Fig. 7 is disposed on the assembly substrate 91, and then both are set on the chuck stage 70 as shown in Fig 5. Because of a suction force of the vacuum suction channel 73 shown in Fig. 6, the assembly substrate 91 is stably fixed on the chuck stage 70 in tight contact therewith. On the other hand, as shown in Fig. 5, the mold substrate 41 is set on the clamp mechanism 81 of the head plate 80.

The vacuum suction channels 92 and 94 of the assembly substrate 91 are connected to an external vacuum evacuating apparatus through the control valve 95.

Then, the positions of the mold members 40 are detected by the mold position detecting camera 64, and the position of the substrate 50 is detected by the work position detecting camera 65. The positioning mechanism 60 is controlled based on the detection results, in order to precisely position the respective resin films 52 of the substrate 50 and the respective mold members 40 relative to each other in a horizontal direction (in the X-Y plane).

Thereafter, the Z-axis table 63 is raised to bring the assembly substrate 91 close to the mold substrate 41, so that the sealing member 93 on the assembly substrate 91 comes in tight contact with the mold substrate 41. Thus, as shown in Fig. 6, there is formed a sealed space defined by the mold substrate 41, the assembly substrate 91, and the sealing member 93. An assembly S is formed by the sealed space together with the mold members 40 and the substrates 50 contained in the sealed space. Inside the assembly S, the mold pattern 42 formed on the mold member 40 is in contact with a surface of the resin film 52 on the substrate 50.

Next, the inside of the assembly S is made into a negative pressure state by evacuation through the vacuum suction channel 94. Then, the vacuum suction channels 92 and 94 are closed by the control valve 95. Thus, the sealed space of the assembly S is maintained in the negative pressure state, and the substrate 50 is maintained to be fixed on the assembly substrate 91 by the vacuum suction. Therefore, it is possible to maintain the precise positioning of the respective mold members 40 relative to the substrate 50 (resin films 52) in the assembly S. It is also possible to handle the assembly substrate 91 and the mold substrate 41 along with each other.

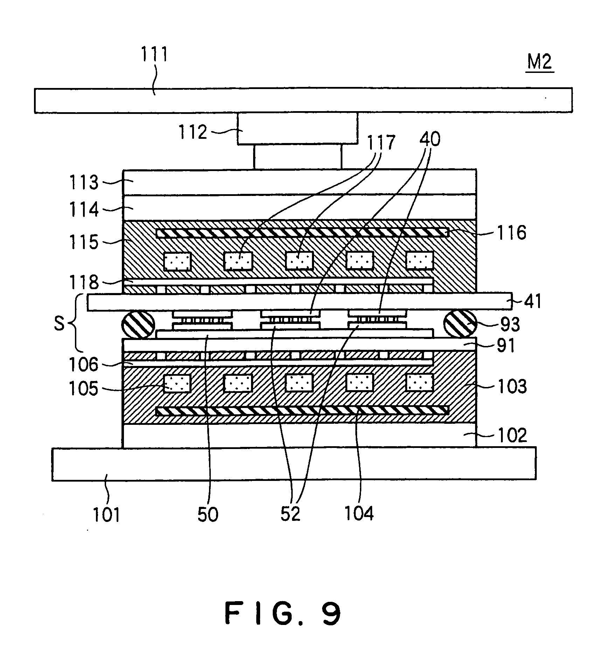

Subsequently, the assembly S of a one-piece structure shown in Fig. 8, in which the assembly substrate 91 and the mold substrate 41 are joined with each other, is sent to the second apparatus (pressing apparatus) M2 shown in Fig. 9. The second apparatus M2 includes a press plate 103 supported by a base plate 101 and a heat-insulation plate 102. The press plate 103 is provided with a heater 104, a cooling mechanism 105, and a vacuum suction channel 106.

A press plate 115 is disposed above the press plate 103, which are opposed to each other. The press plate 115 is supported by a base plate 111, through a heat-insulation plate 114, a flange 113, and an AC servo press 112. The press plate 115 is provided with a heater 116, a cooling mechanism 117, and a vacuum suction channel 118.

The second step of the imprinting method carried out by the second apparatus M2 is described.
First, the assembly S of a one-piece structure shown in Fig. 8 is disposed on the press plate 103, and is then fixed on thereon by a suction operation of the vacuum suction channel 106. Next, the upper press plate 115 is lowered by the AC servo press 112 to bring the press plate 115 into contact with the mold substrate 41 of the assembly S. Then, the mold substrate 41 of the assembly S is fixed on the press plate 115 by a suction operation of the vacuum suction channel 118.

Subsequently, the press plate 115 is further lowered so as to tightly clamp the assembly S between the upper and lower press plates 115 and 103 at a predetermined load of, e.g., a few tons, depending on conditions such as the number of the mold members 40. At the same time, a cooling operation by the cooling mechanisms 105 and 117 is stopped, and the assembly S is heated by the lower heater 104 and the upper heater 116 to a predetermined temperature (for example, 100°C).

In this manner, the mold patterns 42 of the mold members 40 are pressed onto of the respective resin films 52 on the divided regions of the substrate 50. Therefore, the mold pattern 42 is transferred on the resin film 52 so that the transfer pattern 52a (see Fig. 4(b)) is formed. Since the resin film 52 is heat-cured, a shape of the transfer pattern 52a can be maintained. During this process, since the inside of the assembly S is kept in the negative pressure, it is possible to reliably prevent failure of transferring a pattern, which may be caused by mix of bubbles.

After the assembly S is maintained in the clamped state for a predetermined period of time, a cooling operation by the cooling mechanisms 105 and 117 is resumed, while a heating operation by the heaters 104 and 116 is stopped. Thereafter, the assembly S is released from the clamped state by raising the press plate 115 by means of the AC servo press 112, and is then taken out from the second apparatus M2.

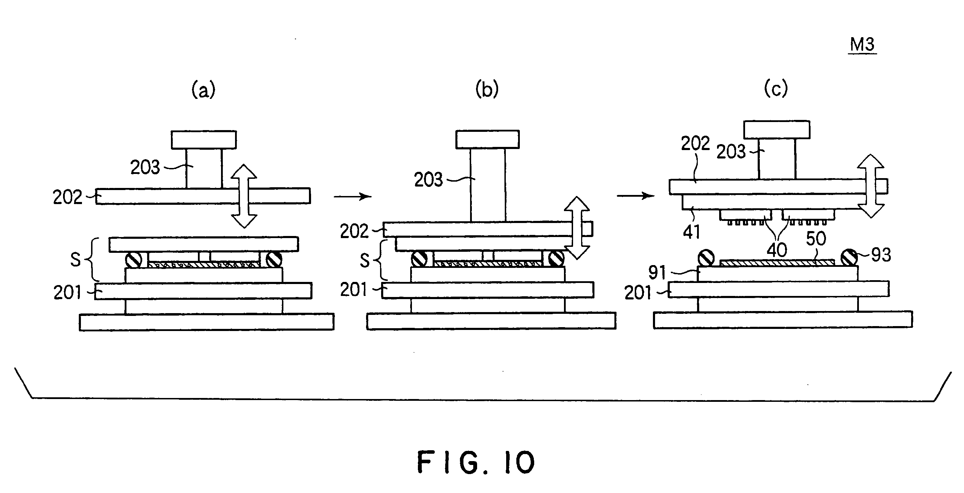

Following thereto, the assembly S is disassembled by a desorption apparatus M3 shown in Fig 10. The detaching apparatus M3 includes a lower suction plate 201, an upper suction plate 202 opposed to the lower suction plate 201, and a cylinder mechanism 203 for vertically driving the upper suction plate 202. The suction plates 201 and 202 are respectively provided with vacuum suction mechanisms, not shown.

As shown in Fig. 10(a), the imprinted assembly S taken out from the second apparatus M2 is disposed on the lower suction plate 201. Then, the assembly substrate 91 of the assembly S is sucked and fixed on the lower suction plate 201. On the other hand, as shown in Fig. 10(b), the upper suction plate 202 is lowered such that the mold substrate 41 is sucked and fixed on the upper suction plate 202.

Then, the control valve 95 (Fig. 8) is opened to release the negative pressure state in the assembly S. Subsequently, as shown in Fig. 10(c), the upper suction plate 202 is raised by the cylinder mechanism 203, so that the mold substrate 41 and the assembly substrate 91 are separated from each other.

Next, the suction of the mold substrate 41 by the upper suction plate 202 is stopped to detach the mold substrate 41 therefrom. Similarly, the suction of the assembly substrate 91 by the lower suction plate 201 is stopped to detach the assembly substrate 91 therefrom. Since the control valve 95 is opened, the substrate 50 is not sucked and fixed on the assembly substrate 91 any longer. Therefore, the imprinted substrate 50 can be taken out. The imprinted substrate 50 is then subjected to the above-described wiring structure forming step, shown in Fig. 13.

As stated above, in the second embodiment, the imprinting process is carried out as follows. First, the assembly S, in which the substrate 50 and the mold substrate 41 are fixedly held in position relative to each other, is formed by the first apparatus M1, and next the assembly S is tightly clamped by the second apparatus M2. Since it is not required for the first apparatus M1 to provide a large clamping force for collectively pressing the plurality of mold members 40 onto the substrate 50, the mold members 40 and the substrate 50 can be highly precisely positioned relative to each other by the first apparatus M1. On the other hand, since it is sufficient for the second apparatus M2 to simply clamping the assembly S in which the substrate 50 and the mold substrate 41 have been held in position relative to each other, a large clamping force of e.g., more than a few tons, can be easily realized for collectively pressing the plurality of mold members 40 onto the substrate 50, without using any complicated mechanism such as a positioning mechanism.

Accordingly, in the second embodiment, it is possible to simultaneously realize a precise positioning of the plurality of mold members 40 relative to the substrate 50 by the first apparatus M1, and an improvement in throughput because the plurality of the mold members 40 are collectively pressed onto the substrate 50 by the second apparatus M2.

By keeping the control valve 95 to be closed after the positioning operation, the assembly S can be reserved as it is, while maintaining the mold member 40 and the substrate 50 in the assembly S to be precisely positioned relative to each other. Therefore, a quantity of production by the imprinting method can be optionally adjusted, which improves a productivity in manufacturing steps, including the imprinting step, of a semiconductor device.

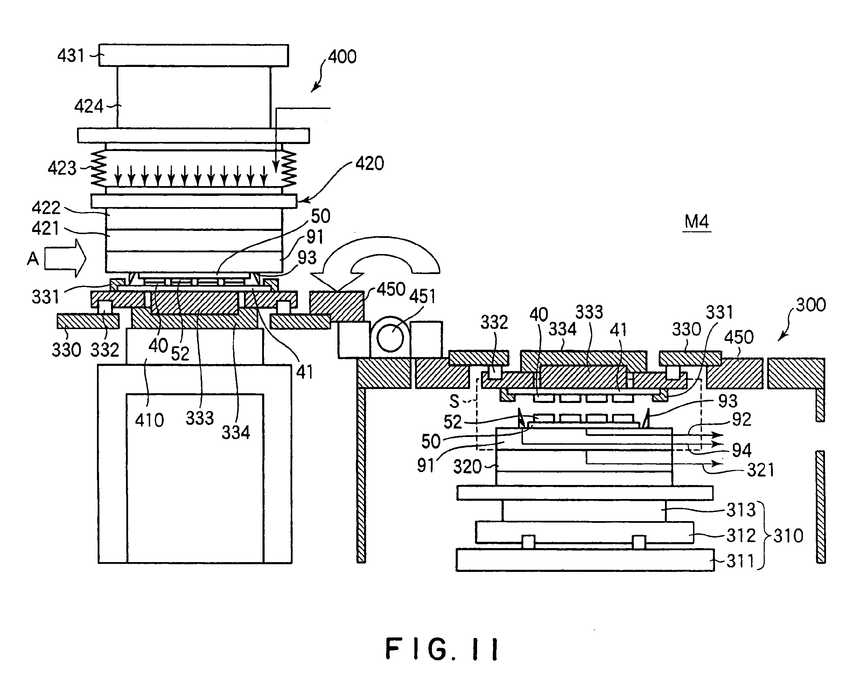

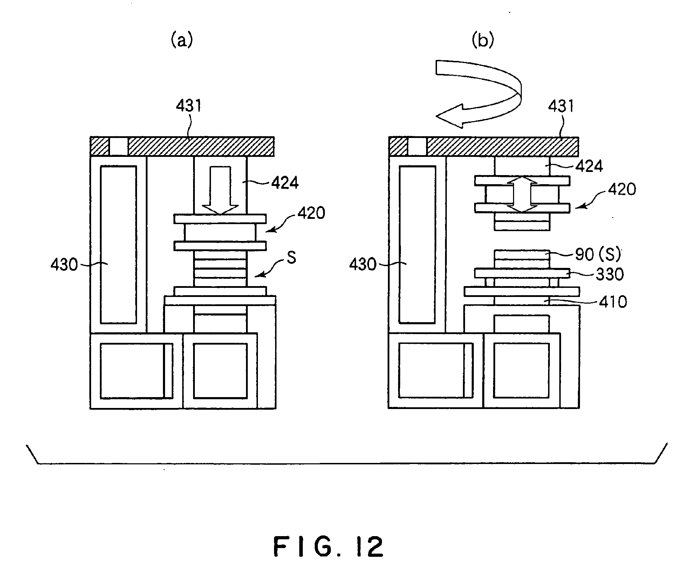

A third embodiment of the present invention is described below, with reference to Figs. 11 and 12.

In the third embodiment, two mechanism units corresponding to the first apparatus M1 and the second apparatus M2 in the second embodiment, respectively, are arranged adjacent to each other. An assembly S is delivered between the mechanism units by a delivering apparatus having a reversal table common to the mechanism units.

An imprinting apparatus M4 in the third embodiment shown in Fig. 11 includes a positioning mechanism unit 300 corresponding to the first apparatus M1 (Fig. 5), a pressing mechanism unit 400 corresponding to the second apparatus M2 (Fig. 9), and a reversal table 450 disposed between the mechanism units 300 and 400.

The positioning mechanism unit 300 includes a positioning mechanism 310. The positioning mechanism 310 is provided with a Y-axis table 311, an X-axis table 312, and a Z-axis table 313, which are stacked in a vertical direction. The Y-axis table 311 and the X-axis table 312 are moved in a horizontal plane in directions perpendicular to each other. The Z-axis table 313 disposed on the Y-axis table 311 and the X-axis table 312 is moved upward and downward.

A chuck stage 320 is disposed on the positioning mechanism 310. The chuck stage 320 is capable of rotating about the Z-axis in a θ rotational direction. Displacement of the chuck stage 320 in the horizontal plane is controlled by displacement of the Y-axis table 311 and the X-axis table 312 of the positioning mechanism 310, while displacement of the chuck stage 20 in the vertical direction is controlled by displacement of the Z-axis table 13 of the positioning mechanism 310. A position of the chuck stage 320 about the Z-axis in the θ rotational direction is controlled by rotational displacement of the chuck stage 320.

A vacuum suction channel 321 is opened to an upper surface of the chuck stage 320. An assembly substrate 91 of the assembly S is detachably fixed on the chuck stage 320 by a suction operation of the vacuum suction channel 321.

Above the chuck stage 320, a head plate (supporting member) 330 opposed to the chuck stage 320 is supported by the reversal table 450. The head plate 330 is provided with a clamp mechanism 331 through a suspension 332. The clamp mechanism 331 can detachably hold a mold substrate 41. A mold heater 333 and a heat-insulation member 334 are disposed on a rear side of the mold substrate 41 held by the clamp mechanism 331. The mold heater 333 can heat mold members 40 of the mold substrate 41 to a predetermined temperature.

Positions of the mold members 40 and the substrate 50 are detected by a mold position detecting camera and a work position detecting camera, not shown. The positioning mechanism 310 is controlled based on the position detection results, so that the mold members 40 and the substrate 50 are positioned relative to each other.

The reversal table 450 is supported by a horizontal rotational shaft 451, and is capable of being rotated in a vertical plane. Thus, the head plate 330 holding the assembly S can be moved by the reversal table 450 between the positioning mechanism unit 300 and the pressing mechanism unit 400 in a reversing manner.

The pressing mechanism unit 400 is provided with a press stage 410, and a pressurizing head part 420 disposed above the press stage 410 to be opposed thereto. The pressurizing head part 420 has a heater 421 for heating the assembly S, a heat-insulation material 422, and a pressurization mechanism 423 for pressing the assembly S onto the press stage 410. An elevating mechanism 424 is disposed for vertically moving the whole pressurizing head part 420.

As shown in Fig. 12, the elevating mechanism 424 is supported by a pivoting arm 431 for pivoting the pressurizing head part 420. The pivoting arm 431 is supported by a support rod 431 supporting the pivoting arm 431, and is capable of pivoting in a horizontal plane. By the pivoting operation of the pivoting arm 431, the pressurizing head part 420 can be moved between a position immediately above the press stage 410 and a retracted position beside the press stage 410 at which a reversing operation of the reversal table 450 is not inhibited.

An imprinting method carried out by the imprinting apparatus M4 of the third embodiment is described below.
First, the mold substrate 41 is fixed on the clamp mechanism 331, with the reversal table 450 being located on a side of the positioning mechanism unit 300. On the other hand, the assembly substrate 91 supporting thereon the substrate 50 is disposed on the chuck stage 320, and the assembly substrate 91 is fixed on the chuck stage 320 through the vacuum-suction by the vacuum suction channel 321. Also, the substrate 50 is vacuum-sucked through a vacuum suction channel 92 to be fixed on the assembly substrate 91.

Thereafter, the positions of the substrate 50 and the mold members 40 are detected by the two not-shown position detecting cameras. By controlling the positioning mechanism 310 and the chuck stage 320 based on the position detection results, the substrate 50 and the mold member 40 are positioned relative to each other, in order that a suitable imprinting process can be carried out.

Then, the Z-axis table 313 is raised to bring the assembly substrate 91 close to the mold substrate 41, so that a sealing member 93 comes in tight contact with the mold substrate 41. At this moment, the mold members 40 are in contact with resin films 52 on the substrate 50.

Under this state, a sealed space defined in the assembly S is evacuated to create therein a vacuum through a vacuum suction channel 94, and then a control valve 95 is closed. Thus, the mold substrate 41 and the assembly substrate 91 are fixedly held in the assembly S.

Next, the pressurizing head part 420 of the pressing mechanism unit 400 is moved to the retracted position beside the press stage 410 (Fig 12(b)). Then, the vacuum suction of the chuck stage 320 by the vacuum suction channel 321 is stopped. Subsequently, the reversal table 450 is turned over, so that the head plate 330 holding the assembly S is moved to the pressing mechanism unit 400 in a reversing manner.

Thus, the head plate 330 is supported on the press stage 410, with the heat-insulation member 334 of the head plate 330 being in contact with an upper surface of the press stage 410. At this time, the assembly S takes a reversed attitude in which the assembly substrate 91 is positioned above the mold substrate 41.

Then, the pressurizing head part 420 is moved immediately above the press stage 410 by the pivoting arm 431. The pressurizing head part 420 is then lowered by the elevating mechanism 424, so as to bring the heater 421 in tight contact with the assembly substrate 91 of the assembly S (left part of Fig. 11 and Fig. 12(a)).

Following thereto, the mold heater 333 and the heater 421 are operated to heat the assembly S to a predetermined temperature. The pressurization mechanism 423 is operated to clamp the substrate 50 and the mold substrate 41 of the assembly S with a predetermined pressing force. In this manner, an imprinting process can be carried out by transferring the mold pattern 42 of the mold member 40 on the resin films 52 of the substrate 50.

After the imprinting process, the pressing force applied by the pressurization mechanism 423 is released. Then, the pressurizing head part 420 is raised by the elevating mechanism 424 and is retracted to the retracted position beside the press stage 410 (Fig. 12(b)). Then, the clamp mechanism 331 is released to take out the assembly S. The thus taken-out assembly S is disassembled by the detaching apparatus M3 shown in the second embodiment. Finally, the imprinted substrate 50 is taken out.

As staged above, in the third embodiment, use of the positioning mechanism unit 300 and the pressing mechanism unit 400 respectively corresponding to the first apparatus M1 and the second apparatus M2 makes it possible to simultaneously realize, similar to the second embodiment, a precise positioning of the plurality of mold members 40 and the substrate 50 relative to each other, and an improvement in throughput because of a collective imprint of the plurality of the mold members 40 on the substrate 50.

In the third embodiment, the assembly S is moved from the positioning mechanism unit 300 to the adjacent pressing mechanism unit 400 while reversing the assembly S, by the delivering apparatus including the reversal table 450. Accordingly, since the assembly S can be rapidly delivered from the former to the latter, a further improvement in throughput can be anticipated.

## Claims

1. An imprinting method of pressing a mold member having thereon a mold pattern onto a film carried on a principal plane of an object to be processed, so as to transfer the mold pattern to the film, the imprinting method comprising the steps of:
(a) arranging a plurality of objects to be processed to be substantially flush with each other; and
(b) transferring the mold pattern to the films carried on the objects by repeating the sub-steps of:
(b1) selectively heating one of the arranged objects;
(b2) positioning the heated object and the mold member relative to each other; and
(b3) pressing the mold member onto the film carried on the object.

2. The imprinting method according to claim 1, wherein
the sub-step (b2) is carried out by recognizing images of the mold member and the object so as to detect respective positions of the mold member and the object.

3. The imprinting method according to claim 1, wherein:
the object is a substrate having a first wiring pattern formed in the principal plane; and
the film is an insulative epoxy resin film covering the first wiring pattern.

4. The imprinting method according to claim 3, wherein
the mold pattern to be transferred on the epoxy resin film provides at least one of a groove pattern and a hole pattern for forming a second wiring pattern to be connected to the first wiring pattern.

5. The imprinting method according to claim 1, wherein
in the sub-step (b3), a pressing force for pressing the mold member onto the object is gradually increased.

6. An imprinting method of pressing a mold member having thereon a mold pattern onto a film carried on a principal plane of an object to be processed, so as to transfer the mold pattern to the film, the imprinting method comprising:
a first step of forming an assembly containing therein the object and the mold member fixedly held in position relative to each other; and
a second step of clamping the assembly to relatively press the mold member onto the object to transfer the mold pattern to the film.

7. The imprinting method according to claim 6, wherein
the first step is carried out by recognizing images of the mold member and the object so as to detect respective positions of the mold member and the object.

8. The imprinting method according to claim 6, wherein:
in the first step, the assembly is formed in which a plurality of objects and a plurality of mold members each corresponding to the respective objects are fixedly held in position relative to each other; and
in the second step, the assembly is clamped so that the mold patterns of the respective mold members are collectively transferred to the films carried on the corresponding objects.

9. The imprinting method according to claim 6, wherein
in the first step, an inside of the assembly is made into a negative pressure state to fixedly hold the object and the mold member, and the inside of the assembly is maintained in the negative pressure state until the second step is completed.

10. The imprinting method according to claim 6, wherein
the object is a substrate having a first wiring pattern formed in the principal plane; and
the film is an insulative epoxy resin film covering the first wiring pattern.

11. The imprinting method according to claim 10, wherein
the mold pattern to be transferred on the epoxy resin film provides at least one of a groove pattern and a hole pattern for forming a second wiring pattern to be connected to the first wiring pattern.

12. An imprinting apparatus for pressing a mold member having thereon a mold pattern onto a film carried on a principal plane of an object to be processed, so as to transfer the mold pattern to the film, the imprinting apparatus comprising:
a holding table for holding a plurality of objects, the holding table including a temperature controlling mechanism capable of independently controlling a heating temperature of each of the objects held by the holding table;
a supporting member for supporting the mold member, the supporting member being disposed to be opposed to the holding table;
a positioning mechanism for positioning the mold member supported by the supporting member and the object held on the holding table relative to each other; and
a pressing mechanism for pressing the supporting member toward the holding table.

13. The imprinting apparatus according to claim 12, wherein
the supporting member is provided with an attitude controlling mechanism for controlling an attitude of the mold member relative to the object.

14. The imprinting apparatus according to claim 12, the imprinting apparatus further comprising:
a first camera for detecting a position of the mold member supported by the supporting member; and
a second camera for detecting a position of the object held on the holding table, wherein
the positioning mechanism carries out a positioning operation based on the positions of the mold member and the object detected by the first and second cameras.

15. The imprinting apparatus according to claim 12, wherein
the pressing mechanism gradually increases a pressing force for pressing the mold member onto the object.

16. The imprinting apparatus according to claim 12, wherein:
the object is a substrate having a first wiring pattern formed in the principal plane; and
the film is an insulative epoxy resin film covering the first wiring pattern.

17. The imprinting apparatus according to claim 16, wherein
the mold pattern to be transferred on the epoxy resin film provides at least one of a groove pattern and a hole pattern for forming a second wiring pattern to be connected to the first wiring pattern.

18. An imprinting apparatus for pressing a mold member having thereon a mold pattern onto a film carried on a principal plane of an object to be processed, so as to transfer the mold pattern to the film, the imprinting apparatus comprising:
a first apparatus including a positioning mechanism for positioning the object and the mold member relative to each other, and a fixing mechanism for fixedly holding the object and the mold member in position relative to each other, the first apparatus forming an assembly containing therein the object and the mold member fixedly held in position relative to each other; and
a second apparatus for clamping the assembly to relatively press the mold member onto the object to transfer the mold pattern to the film.

19. The imprinting apparatus according to claim 18, wherein:
the first apparatus and the second apparatus are arranged adjacent to each other; and
the imprinting apparatus further comprises a delivering apparatus for supporting the assembly to deliver the same from the first apparatus to the second apparatus.

20. The imprinting apparatus according to claim 18, the delivering apparatus including:
a supporting member for supporting the assembly; and
a reversal table for moving the supporting member from the first apparatus to the second apparatus while reversing the supporting member.

21. The imprinting apparatus according to claim 18, the first apparatus further including:
a first camera for detecting a position of the mold member; and
a second camera for detecting a position of the object, wherein
the positioning mechanism of the first apparatus carries out a positioning operation based on the positions of the mold member and the object detected by the first and second cameras.

22. The imprinting apparatus according to claim 18, the assembly containing:
a first holding member for holding the object;
a second holding member for holding the mold member, the second holding member being disposed to be opposed to the first holding member; and
a sealing member arranged between the first holding member and the second holding member to surround the object and the mold member, wherein
the fixing mechanism of the first apparatus makes an inside of a sealed space defined by the first and second holding members and the sealing member into a negative pressure state to fixedly hold the object and the mold member relative to each other.

23. The imprinting apparatus according to claim 18, the assembly containing:
the object having a plurality of divided regions each having thereon the film; and
a plurality of mold members respectively corresponding to the divided regions of the object, wherein
the mold patterns of the mold members are collectively transferred to the films carried on the respective divided regions of the object when the second apparatus clamps the assembly.

24. The imprinting apparatus according to claim 18, wherein:
the object is a substrate having a first wiring pattern formed in the principal plane; and
the film is an insulative epoxy resin film covering the first wiring pattern.

25. The imprinting apparatus according to claim 24, wherein
the mold pattern to be transferred on the epoxy resin film provides at least one of a groove pattern and a hole pattern for forming a second wiring pattern to be connected to the first wiring pattern.
